(19) Europäisches Patentamt

European Patent Office

Office européen des brevets

(11) **EP 0 758 840 B1**

(12) **EUROPEAN PATENT SPECIFICATION**

(45) Date of publication and mention
of the grant of the patent:
**09.04.2003   Bulletin 2003/15**

(21) Application number: **96902447.0**

(22) Date of filing: **15.02.1996**

(51) Int Cl.[7]: $H05K\ 3/46$, $H05K\ 3/38$, $H05K\ 1/09$

(86) International application number:
**PCT/JP96/00331**

(87) International publication number:
**WO 96/025838 (22.08.1996 Gazette 1996/38)**

(54) **COPPER FOIL AND HIGH-DENSITY MULTI-LAYERED PRINTED CIRCUIT BOARD USING THE COPPER FOIL FOR INNER LAYER CIRCUIT**

KUPFERFOLIE FÜR INNENSCHICHTSCHALTUNGEN VON MEHRSCHICHTIGEN LEITERPLATTEN HOHER DICHTE

FEUILLE DE CUIVRE POUR CIRCUIT IMPRIME MULTICOUCHE A HAUTE DENSITE

(84) Designated Contracting States:
**BE DE FR GB IT LU NL SE**

(30) Priority: **16.02.1995   JP 5036895**

(43) Date of publication of application:
**19.02.1997   Bulletin 1997/08**

(73) Proprietor: **MITSUI MINING & SMELTING CO., LTD.**
**Chuo-ku Tokyo-to 103 (JP)**

(72) Inventors:
 • **OHARA, Muneharu**
  **Hasuda-shi, Saitama 349-01 (JP)**
 • **MITSUHASHI, Masakazu**
  **Saitama 362 (JP)**
 • **SAIDA, Muneo**
  **Tokyo 154 (JP)**

(74) Representative: **Modiano, Guido, Dr.-Ing. et al**
**Modiano, Josif, Pisanty & Staub,**
**Baaderstrasse 3**
**80469 München (DE)**

(56) References cited:
**EP-A- 0 250 195**     **EP-A- 0 616 489**
**JP-A- 2 026 097**     **JP-A- 2 241 087**
**JP-A- 2 303 190**     **JP-B- 53 039 327**
**JP-B- 54 038 053**     **US-A- 4 997 516**

 • **DATABASE WPI Week 8143 Derwent Publications Ltd., London, GB; AN 80-28013c XP002070660 & JP 56 041 196 B (MITSUI MINING & SMELTING) , 26 September 1981**

**Description**

Technical Field

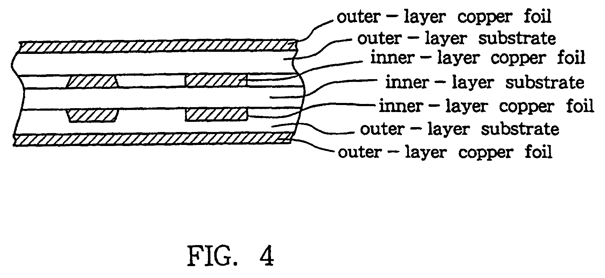

This invention relates to copper foils for use in an inner-layer of a high-density multilayer printed circuit and also to a high-density multilayer printed circuit board using said copper foils therein. More particularly, it relates to such copper foils which will ensure a high etching factor and will be able to be etched to form a very high-density circuit by laminating the glossy (or smooth) side of the copper foils on an inner-layer substrate and which will allow the breakage and peeling-off of electrodeposited protrusions to be lessened when the copper foils are handled in the course of a process, securely adhere to an outer-layer substrate and maintain their dimensional accuracy at the time of light exposure to a resist by forming uniform electrodeposited micro-protrusions on the matte (or rough) side of the copper foils to use the matte side as a side to be coated with a resist, and it also relates to such a high-density multilayer printed circuit board using said copper foils therein. In this specification, there will be explained hereunder with reference to, for example, a high-density multilayer printed circuit board having two inner-layer circuits and two outer-layer circuits as indicated in Fig. 4 which is a schematic cross-sectional view of said printed circuit board.

Background Art

As is seen from Fig 4, a conventional multilayer board has been prepared by laminating ordinary copper foils each having nodules (a kind of electrodeposited protrusions) formed on its matte side (matte-side roughness Rz = about 7.0 µm, glossy-side roughness Rz = about 0.7 µm) to an inner-layer substrate (one of the foils being laminated to one side of the substrate and the other to the other side thereof) with the matte side of each foil facing to the substrate, etching the glossy side of each foil to form a circuit, subjecting the thus formed circuits to black oxide treatment, then laminating an outer layer (consisting of a copper foil and a substrate with which the foil is bonded) onto each of the thus treated circuits and then etching the copper foil of the outer layer to form outer-layer circuit.

In this black oxide treatment, not only the control of the treating solution is complicated but also the resulting copper oxide film will be dissolved in a hydrochloric acid solution at the step of pretreatment of electroless copper plating for fabricating through holes whereby haloing phenomena are made liable to be caused and the insulation properties and interlayer connecting reliability of the resulting circuit board are made apt to be degraded.

In order to overcome these defects, a step of chemical reduction has recently been specially carried out after the black oxide treatment. The black oxide treatment, however, requires a higher cost since it needs a step of rinsing because of the use of a concentrated alkaline solution in the treatment and further needs a step of chemical reduction.

To solve these problems mentioned above, a "both sides-treated" copper foils (double-treated copper foils) have hitherto been proposed (refer to Japanese Pat. Appln. Laid-Open Gazette No. Hei 4-284690 or 284690/92 and Treatise by Bucci et al., IPC-TP-501). However, the double-treated copper foils are laminated on an inner-layer substrate with their matte (or rough) side facing thereto. In this state, it is difficult to realize a fine high-density circuit since it is the glossy (or smooth) side at which etching starts and, therefore, the etching factor will not be increased.

Moreover, it is a serious problem that electrodeposited protrusions formed on the resist-coated side of a copper foil are peeled or broken when an inner-layer substrate and the copper foil are dressed together or the copper foil is etched. Therefore, Japanese Pat. Appln. Laid-Open Gazette No. 369240/92 indicates that the problem is solved by using a protective film.

In addition, the adhesion of the copper foil on the inner-layer substrate to the outer-layer substrate is secured by forming nodules on the glossy side of the copper foil on the inner-layer substrate as described above, and, to this end, electrodeposited protrusions (nodules) are increased in size. Thus, there is raised a more serious problem that, for example, the electrodeposited protrusions on the resist-coating side are broken in the course of a subsequent process.

Furthermore, a serious problem of the existing double-treated copper foil is a deficiency of the formability of a fine or minute circuit due to uneven light exposure to the resist caused by the size-increased or enlarged electrodeposited protrusions formed on the glossy side of the copper foil.

Disclosure of Invention

The object of the present invention is to solve the problems of the prior art and provide an inner-layer copper foil for use in a high-density multilayer printed circuit, which enables a fine or minute high-density inner-layer circuit to be obtained by etching and prevents the electrodeposited protrusions formed on the resist-coating side of the inner-layer copper foil from being broken or fallen off in the course of a subsequent process for fabricating a multilayer printed circuit board, and said object is also to provide a high-density multilayer printed circuit board using said copper foils therein.

**EP 0 758 840 B1**

The above object of the present invention is achieved by provision of the copper foil and the high-density multilayer printed circuit board each shown below.

The present invention resides basically in a specific copper foil for use in the inner layer of a high-density multilayer printed circuit, which is prepared by forming dendritic or nodular electrodeposites on the glossy side of a starting electrodeposited copper foil and forming on the matte side acicular dendritic or nodular electrodeposited micro-protrusions.

More particularly, the present invention resides basically in a specific copper foil for use in the inner layer of a high-density multilayer printed circuit, which is characteristically prepared by forming dendritic or nodular electrodeposites on the glossy side of a starting copper foil in accordance with the disclosure of Japanese Pat. Appln. Laid-Open Gazette No. 270331/94, and forming uniform electrodeposited micro-protrusions uniformly on the whole matte side of the starting copper foil in accordance with the method disclosed in Japanese Patent Publication No. 41196/81.

The present invention will be explained below in detail.

Starting copper foils which may be used in the present invention include a normal electrodeposited copper foil, a copper foil with large elongation at high temperature, and a copper foil with a low profile matte side.

An electrodeposited copper foil with large elongation at high temperature will be explained below.

There will be described hereunder the treatment of the glossy side of a copper foil to be laminated facing the glossy side of the copper foil to an inner-layer substrate when an inner-layer circuit is to be fabricated.

The roughness of the glossy side where copper is started to be deposited when an electrodeposited copper foil is to be manufactured is 0.5 to 1.3 µm in terms of Rz value (JIS B 0601) and the glossy side has a very small number of protrusions per unit area as compared with the matte side of the same copper foil. Therefore, no enough electrodeposited protrusions are formed on the glossy side in spite of needing a great number of electrodeposited protrusions on the glossy side to obtain good adhesion to an inner-layer substrate unless a large current is applied as compared with that required for electrolysis for forming electrodeposited protrusions on the matte side. It is preferable that said electrodeposited protrusions have a height of 0.2 to 2 µm and they be dendritic or nodular electrodeposites, for example. It is illustrated in Japanese Pat. Appln. Laid-Open Gazette No. 270331/94 that such electrodeposited protrusions as above may be formed on the glossy side of a copper foil by electrolyzing a copper sulfate plating bath containing 12 g copper/l and 100 g sulfuric acid/l for 10 seconds at normal temperature of the bath and a current density of 30 A/dm$^2$ and further electrolyzing a copper sulfate bath containing 60g copper/l and 100g sulfuric acid/l for 10 seconds at a bath temperature of 40°C and a current density of 30 A/dm$^2$. Under the above conditions, the roughness of the glossy side is changed from 1.2µm to 2.7µm in terms of Rz value.

According to the present invention, it is possible to further form acicular or nodular electrodeposited micro-protrusions on a layer of electrodeposited protrusions obtained as mentioned above and formed on the glossy side thereby to greatly improve the resulting copper foil in chemical resistance and peeling strength with respect to an inner-layer substrate on which the copper foil is to be laminated. Minute uniform electrodeposited protrusions meeting the requests have heretofore been obtained by adding arsenic to the copper sulfate plating bath. At present, however, this copper sulfate plating bath containing arsenic cannot be allowed to be used in view of environmental pollution and operators' health. Therefore, the inventors of the present invention have now found that finer and more uniform electrodeposited protrusions than those formed by arsenic addition electrolysis can be obtained by using the benzoquinoline-based organic additive disclosed by Japanese Patent Publication No. 41196/81 in the following bath and effecting electrolysis thereof under the following conditions.

Copper concentration: 6 to 12 g/lit
Sulfuric acid concentration: 15 to 45 g/lit
Benzoquinoline-based additive concentration: 10 to 200 mg/lit
Temperature: Room temperature
Current density: 2 to 15 A/dm$^2$

The following is a description of the treatment of the matte side of a copper foil, on which a resist is to be coated, when an inner-layer circuit is to be fabricated.

Though the roughness of the matte side of a copper foil with large elongation at high temperature varies depending on the thickness of the copper foil, it is 4 to 7.5 µm in terms of Rz value when the copper foil has a thickness of 18 µm. When attempting to form nodules on the matte side of such a copper foil as above in a usual manner, large electrodeposited protrusions will be concentrated on the tips of convex parts of the uneven matte (rough) side of the copper foil whereby the roughness of the matte side is increased to 6 to 8.5 µm in terms of Rz value because the current is concentrated on said tips. When the glossy side is subjected to a pressing operation required for laminating the glossy side on the inner-layer substrate or is subjected to an etching operation, the large electrodeposited protrusions so formed on said tips will easily fall off or break due to an external force whereby the strength of adhesion of the copper foil to the outer-layer substrate is decreased or the powder produced by the electrodeposited protrusions

3

being partly broken causes a short circuit between the resulting circuits.

Moreover, because the roughness of the matte side exceeds 7.5 μm in terms of Rz value, there are raised various problems such as a decrease of the inter-layer insulation performance and a cause of the occurrence of migration at currently urged attempt to decrease the thickness of an insulating layer between the layers of a multilayer board.

While, the method applied in the present invention makes it possible to form acicular or nodular electrodeposited micro-protrusions uniformly overall on the matte side of the copper foil. It is preferable that the electrodeposited micro-protrusions have a height of 0.05 to 0.5 μm.

In a case where such copper foils as above are used in the preparation of a circuit board according to the present invention, the electrodeposited micro-protrusions deposited on the copper foils will be little broken or fallen off even when the foils are subjected to pressing and the like. If the electrodeposited micro-protrusions fall off, a problem of short circuit will hardly be raised because the particle diameter of the falling-off protrusions is very small. Moreover, the part of the electrodeposited micro-protrusions which falls off is only a small part of the tips of the convex parts of the matte side and a great part of the electrodeposited micro-protrusions still remain at the foot thereof whereby enough strength of adhesion of the copper foil to the outer-layer substrate can be maintained.

A copper foil obtained through the above procedure has a glossy side having dendritic or nodular electrodeposited protrusions and a matte side having micro electrodeposited protrusions.

As indicated in Fig. 4, in a case where the glossy side of the copper foils having nodules formed thereon, as a primary laminating side for an inner-layer substrate, and the inner layer are press-formed together to prepare an inner-layer copper-clad laminate, after which the copper foils are etched to form circuits. When etched, the etching rate is low in the early stage of the etching because the crystals of the matte side are coarse grain difficuit to etch and etching starts from the matte side of the copper foil but, as the etching proceeds, the etching rate gradually increases owing to the presence of finer crystals and a greater number of crystal grain boundaries toward the glossy side. Further the residual copper particles bedded in the substrate are smaller, so they only used a short time to be etched away. Because of this, an etching time to obtain a predetermined circuit width is shortened, side etching is lessened and a circuit having a large etching factor can be prepared, as disclosed in Japanese Pat. Appln. Laid-Open Gazette No. Hei 6-270331 (or No. 270331/94).

Moreover, when using a resist, there have been heretofore raised various problems such as the falling-off of the electrodeposited protrusions at the time of the resist being peeled off, the remains of the resist in the case of conventional large electrodeposited protrusions.

In the case of the formation of fine and uniform electrodeposited micro-protrusions on the matte side applied by the present invention, such problems as above are hardly raised because it is possible to hold the resist uniformly on the whole side as in the case of the black oxide treatment.

Moreover, because the electrodeposited micro-protrusions are made of metallic copper, a haloing phenomenon due to a copper oxide film is not presented at all in the steps of drilling and through-hole plating.

Furthermore, the side of the copper foil circuit (the matte side) laminated to the outer-layer substrate has high chemical resistance because minute or fine electrodeposited micro-protrusions are highly densely present on it.

Then, the copper foil treated so as to have electrodeposited micro-protrusions formed thereon by electrodeposition is subjected to rust-preventive treatment. It is possible to use a general method for the rust prevention of copper foils in order to effect said rust-preventive treatment. When the copper foil is used in making a circuit, it is known that the rust prevention using zinc, a zinc-tin alloy or a zinc-nickel alloy is very effective for prevention of heat oxidation, improvement of close adhesiveness to a substrate, and prevention of under-etching of the copper foil from the side when the copper foil is subjected to press adhesion to a substrate, circuit etching, plating, and the like. This is disclosed in Japanese Patent Publications Nos. 56758/83 and 47038/92.

Furthermore, Japanese Patent Publication No. 53079/83 discloses that the above effect is further enhanced by heating the rust prevented layer obtained through the above procedure to diffuse zinc, the zinc-tin alloy or the zinc-nickel alloy thereby converting it into a binary alloy or a ternary alloy.

Furthermore, after the rust preventive treatment, it is possible to apply the chromate treatment or silane coupling agent treatment to the copper foil before the thermally diffusing treatment. The chromate treatment solution may be an acid solution or an alkaline solution, and the treatment method may be a dipping method or an electrolytic method. The silane coupling agent includes γ-(methacryloxypropyl)trimethoxysilane, β-(3,4-epoxycyclohexyl)ethyltrimethoxysilane, γ-glycidoxypropyltrimethoxysilane, γ-glycidoxypropylmethyldiethoxysilane, N-β-(aminomethyl)-γ-aminopropyltrimethoxysilane, N-β-(aminoethyl)-γ-aminopropylmethyldimethoxysilane, or γ-aminopropyltriethoxysilane. A typical treatment condition is shown below.

Coupling agent concentration: 1 to 10 g/lit
pH: Depends on the coupling-agent pH
Temperature: Room temperature

Treatment time: 5 to 10 sec

In general, washing is not done after the coupling agent treatment is applied.

Brief Description of Drawings

Fig. 1 is a microphotograph (x5,000) showing the crystal structure of fine uniform electrodeposited protrusions on the convex parts of the matte side of a copper foil, the protrusions having been obtained in Example 1;
Fig. 2 is a microphotograph (x5,000) showing the crystal structure of electrodeposited micro-protrusions on the electrodeposited protrusions of the glossy side of the same copper foil as above, the protrusions having been obtained in Example 1;
Fig. 3 is a microphotograph (x5,000) showing the crystal structure of electrodeposited micro-protrusions on the electrodeposited protrusions of the glossy side of a copper foil, the protrusions having been obtained in Example 2; and
Fig. 4 is a schematic cross-sectional view of a high-density multilayer printed circuit board having two inner-layer circuites and two outer-layer circuites.

The present invention is described below in detail in accordance with embodiments.

Best Mode for Carrying Out the Invention

The present invention will be better understood by the following Examples in comparison with the Comparative Examples.

Example 1

A 18 um thick electrodeposited copper foil (matte side roughness Rz = 5.5 um, glossy side roughness Rz = 0.6 $\mu$m) was first treated to have electrodeposited protrusions (nodules) formed on its glossy side by applying a copper sulfate bath with a copper concentration of 12 g/lit and a sulfuric acid concentration of 100 g/lit, at a current density of 30 A/dm$^2$ and normal temperature for 10 sec and was then plated to cover the nodule-formed glossy side with copper plating by using a solution with a copper concentration of 60 g/lit and a sulfuric acid concentration of 100 g/lit at a solution temperature of 40 °C and a current density of 30 A/dm$^2$.
Then, the copper foil was treated to have fine and uniform electrodeposited micro-protrusions formed on its matte side by applying an electrolytic bath with a copper concentration of 12 g/lit, a sulfuric acid concentration of 45 g/lit and an $\alpha$-naphthoquinoline concentration of 50 mg/lit as an additive at a current density of 10 A/dm$^2$ for 10 seconds.

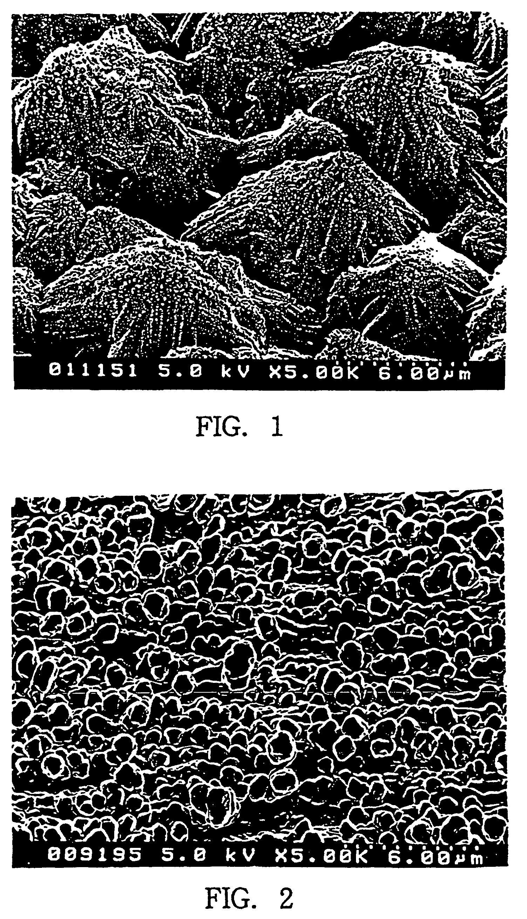

Fig. 1 shows fine uniform electrodeposited micro-protrusions formed under the above conditions on the matte side, and Fig. 2 shows the state of electrodeposited micro-protrusions formed on the glossy side.
Subsequently, the copper foil so treated was subjected at each of its glossy and matte sides to rust-preventive treatment by applying an electrolytic bath containing 10 g/lit of zinc sulfate, 2.5 g/lit of tin sulfate and 50 g/lit of potassium pyrophosphate at a current density of 2.5 A/dm$^2$ for 10 sec and at pH of 10 and room temperature, with the result that 16 mg/m$^2$ of zinc and 6 mg/m$^2$ of tin were electroplated to each of the glossy and matte sides.
The copper foil so subjected to rust-preventive treatment was subsequently heated in an oven at 200 °C for 10 seconds to evaporate the moisture attached to the surface of the copper foil and simultaneously diffuse zinc-tin alloy thereby converting it into a ternary alloy rust-prevented layer thereby to prepare an inner-layer copper foil for use in making a high-density multilayer printed circuit. Using the thus prepared copper foils, a multilayer printed circuit board was fabricated by the following method. At that time, the following evaluation test was made. The fabrication of the circuit board was carried out as follows:
Three of 0.18 mm thick epoxy resin-impregnated glass fiber prepregs were put one upon another to form a substrate (an inner-layer substrate), after which the copper foils so prepared were laminated respectively on the sides (faces) of the inner-layer substrate with their glossy side facing thereto and the whole was then pressed together under heat thereby to fabricate an inner-layer laminate. The copper foils laminated on the inner-layer substrate were etched with a solution of ferric chloride-hydrochloric acid so as to obtain circuits having a line width of 80 $\mu$m and a line space of 80 $\mu$m and, thereafter, 0.18 mm thick epoxy resin-impregnated glass fiber prepregs were placed respectively on the thus obtained circuits, ordinary 18 $\mu$m thick electrodeposited copper foils were placed respectively on said prepregs to form outermost layers and then the whole was again pressed under heat. Subsequently, masking was applied to the predetermined portions of the outermost-layer copper foils and the partly masked copper foils were'treated by the ordinary method to form outer-layer circuits whereby a multilayer printed circuit board consisting of four layers of circuits was obtained.

The results of the aforementioned evaluation test made on the thus obtained curcuit board are shown in the following Table 1. The methods for evaluation of these circuit boards used in the test are as indicated hereunder.

(1) Inner-layer copper foil peeling test

According to JIS C 6486

(2) Hydrochloric acid resistance test

There were prepared two kinds of copper foil-laminated boards, one kind thereof being prepared by laminating the matte side of one copper foil of this invention onto a substrate and the other thereof being prepared by laminating the glossy side of another copper foil of this invention on a substrate. The copper foils laminated respectively on the substrates were etched so as to form circuits respectively having a line width of 0.2 mm, immersed in a 1 : 1 aqueous solution of hydrochloric acid for 30 minutes and then subjected to the peeling test in accordance with JIS C 6481 before and after their immersion in order to measure their deterioration rate (degradability).

(3) Evaluation for crushability of the electrodeposited protrusions at the time of pressing

The inner-layer laminate fabricated as previously mentioned was then pressed to observe the resist-coating sides contacting with the panel board of a press at the time of pressing by the use of a scanning electron microscope (SEM).

(4) Measurement of inner-layer circuit etching factor

The inner-layer circuit fabricated by the above method was then measured for its upper end width (A) and lower end width (B) by the use of the SEM photo and its thickness (H) whereby an etching factor is calculated in accordance with the following formula.

$$\text{Etching factor} = H \times 2/(B - A)$$

The etching factor is measured at 20 points of the same circuit portion to find the dispersion of the etching factors thereby to evaluate how the scattering of light at the resist due to the electrodeposited protrusions influences the minute circuit.

Example 2

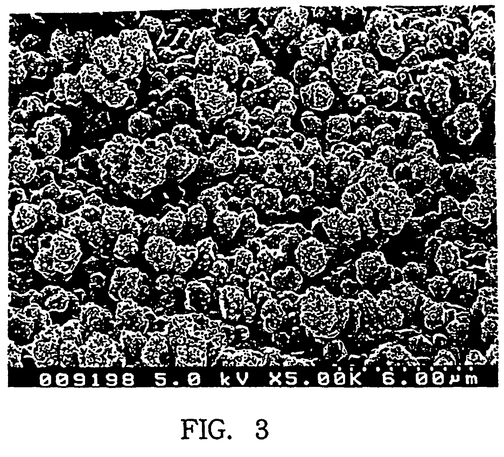

Using the same electrodeposited copper foil as used in Example 1, the matte side thereof was treated under the same conditions as in Example 1 to form minute uniform electrodeposited micro-protrusions on the matte side, while the glossy side of the copper foil was treated in the same manner as in Example 1 to form electrodeposited protrusions and then further treated with the same electrolytic solution as used for the formation of minute uniform electrodeposited micro-protrusions on said matte side. In this case, a current density of 15 A/dm$^2$ and an electrolysis time of 10 seconds were used. Fig. 3 shows the state of the electrodeposited micro-protrusions formed on the electrodeposited protrusions of the glossy side of said copper foil.

Then, rust preventive treatment and heating treatment were performed under the same conditions as used in Example 1.

The glossy side of the copper foils so treated was laminated on an inner-layer substrate to make a multilayer printed circuit board as in Example 1 which was then subjected to the same evaluation test as in Example 1. Table 1 shows the test results.

Example 3

Using the same electrodeposited copper foil as used in Example 1, the matte side thereof was treated so as to form fine and uniform electrodeposited micro-protrusion thereon in the same manner as in Example 1 while the glossy side of the copper foil was also treated so as to form electrodeposited protrusions, after which the copper foil is subjected to rust-preventive treatment, and dipping in a solution of 2 g/lit of chromic acid at pH 4 and 30 °C. Then, the solution was electrolyzed using the copper foil as a cathode and a stainless steel plate as an anode at a current density of 1 A/dm$^2$ for 5 seconds (chromate treatment). The copper foil so treated was rinsed with water and then subjected to heat treatment as in Example 1.

The glossy sides of the copper foils so heat treated were respectively laminated on an inner-layer substrate to make a multilayer printed circuit board as in Example 1. The circuit board so made was then subjected to the same evaluation test as in Example 1 with the result being shown in Table 1.

Example 4

The same electrodeposited copper foil as used in Example 1 was subjected to electrodeposited protrusions formation, rust preventive and chromate treatments as in Example 3, thereafter passed through a bath into which a 5 g/lit solution of γ-glycldoxypropyltrimethoxysilane was showered for 5 seconds (silane coupling agent treatment), freed from excess solution by rubber rolls and then heat treated as in Example 1.

The glossy side of the copper foils so treated was laminated on an inner-layer substrate to make a multilayer printed circuit board as in Example 1 which was then subjected to the same evaluation test as in Example 1. Table 1 shows the test results.

Example 5

Using the same electrodeposited copper foil as used in Example 1, the matte side thereof was treated under the same conditions as in Example 1 so as to form fine and uniform electrodeposited micro-protrusions thereon while the glossy side of the copper foil was treated so as to form electrodeposited protrusions thereon as in Example 1 and then further treated with the same electrolytic solution as used for forming the fine and uniform electrodeposited micro-protrusions on the matte side. Then, the copper foil so treated was subjected to the same chromate treatment, silane coupling agent treatment and heating treatment as in Example 4.

The glossy side of the copper foils so subjected to the above treatments was laminated on an inner-layer substrate to make a multilayer printed circuit board as in Example 1, after which the circuit board so made was subjected to the same evaluation test as in Example 1. Table 1 shows the test results.

Example 6

The procedure of Example 5 was followed except that an electrodeposited copper foil having low profile matte side (matte side roughness = a Rz value of 3.0 μm, glossy side roughness = a Rz value of 0.6 μm) was substituted for the electrodeposited copper foil used in Example 5, thereby to obtain a treated copper foil.

The glossy side of the copper foils so treated was laminated on an inner-layer substrate to make a multilayer printed circuit board as in Example 1, after which the circuit board so made was subjected to the same evaluation test as in Example 1. Table 1 shows the test results.

Comparative Example 1

Using a 18 μm thick electrodeposited copper foil (matte side roughness = a Rz value of 5.5 μm, glossy side roughness = a Rz value of 0.6 μm), the matte side thereof was immersed in a copper sulfate bath containing 12 g/lit of copper and 100 g/lit of sulfuric acid, and the bath was electrolyzed at normal temperature and a current density of 20 A/dm$^2$ for 10 seconds. Thereafter, the matte side so treated was plated using a solution containing 60 g/lit of copper and 100 g/lit of sulfuric acid at a temperature of 40 °C and a current density of 30 A/dm$^2$.

Then, the rust preventive treatment, chromate treatment, and heat treatment were applied to the copper foil as in Example 3.

The copper foils so treated were used in fabricating an inner-layer board as in Example 1 except that the matte side of the copper foil was laminated on inner-layer substrate inversely to the case of Example 1. A resist was formed on the glossy side of the copper foil, and the resist-formed copper foil was etched to form a circuit which was then subjected to black oxide treatment with a commercially available black oxide treating liquid. Thereafter, a multilayer printed circuit board was made as in Example 1 and then subjected to the same evaluation test as in Example 1. Table 1 shows the test results.

Comparative Example 2

The same electrodeposited copper foil as used in Comparative Example 1 was treated so as to have electrodeposited protrusions formed on the matte side of the foil under the same conditions as used in Comparative Example 1, while said copper foil was treated so as to have electrodeposited protrusions formed on the glossy side of the foil in an electrolytic bath having the same composition as that used for the formation of nodules on the matte side and electrolyzing said bath at a current density of 30 A/dm$^2$ for 10 seconds, and the glossy side was subsequently plated in the same manner as in the matte side. The copper foil was further subjected to rust-preventive treatment, chromate treatment and heat treatment in the same manner as in Comparative Example 1.

The copper foils so treated were then respectively laminated on an inner-layer substrate with the matte side facing thereto to fabricate a multilayer printed circuit board in the same manner as in Example 1. The printed circuit so fabricated was subjected to the same evaluation test as in Example 1 with the result being indicated in Table 1.

Comparative Example 3

The same electrodeposited copper foil as used in Comparative Example 1 was subjected to electrodeposited protrusions formation treatment, rust-preventive treatment, chromate treatment and heat treatment under the same conditions as used in Comparative Example 2.

The copper foils so treated were laminated respectively on an inner-layer substrate with the glossy side facing thereto thereby to fabricate a multilayer printed circuit board which was then subjected to the same evaluation test as used in Example 1. The results are shown in Table 1.

EP 0 758 840 B1

## T a b l e   1

| Example and Comp. Ex. | Peel strength (Kg/cm) | | Hydrochloric acid resistance degradability (%) | | Crushability under press | Etching factor | |
|---|---|---|---|---|---|---|---|
| | Inner-layer side | Outer-layer side | Mat face side | Glossy face side | | Average | coefficiency of variation(%) |
| Example 1 | 1.2 | 1.1 | 5 | 10 | Extremely low | 5.3 | 1.8 |
| Example 2 | 1.3 | 1.1 | 5 | 7 | ditto | 5.3 | 1.8 |
| Example 3 | 1.2 | 1.2 | 2 | 4 | ditto | 5.3 | 1.8 |
| Example 4 | 1.2 | 1.3 | 0 | 4 | ditto | 5.3 | 1.8 |
| Example 5 | 1.4 | 1.3 | 0 | 0 | ditto | 5.3 | 1.8 |
| Example 6 | 1.4 | 1.3 | 0 | 0 | ditto | 6.7 | 1.8 |
| Comp. Ex.1 | 2.0 | 1.0 | 2 | 100 | None | 3.2 | 3.4 |
| Comp. Ex.2 | 2.0 | 1.2 | 2 | 4 | Low | 3.2 | 3.4 |
| Comp. Ex.3 | 1.2 | 2.0 | 2 | 4 | High | 5.3 | 3.7 |

Industrial Applicability

Copper foils for use in an inner-layer of a high-density multilayer printed circuit of the present invention enable a high etching factor to be obtained by having treated the glossy side of the copper foils so as to form electrodeposited protrutions thereon and having used the thus treated glossy side as a primary lamination side for laminating the copper foils on an inner-layer substrate. Further, the copper foils of the present invention are provided on the matte side with fine and uniform electrodeposited micro-protrusions whereby breakage and falling-off of the electrodeposited protrusions are lessened at the time of handling such as pressing, the copper foils can be adhered to an outer-layer substrate very securely and the dimensional accuracy of the circuit lines at the time of light exposure to a resist coated thereon can be well maintained.

Further, a decrease in insulation between the layers is lessened in a multilayer board using the copper foils of the present invention therein since the roughness of the matte side of the copper foils will not be increased by the treatment of electrodeposited micro-protrusions formation on the matte side.

The chemical resistance and adhesion strength of the copper foils after the laminate thereof on an inner-layer substrate, are made more effective or powerful by having subjected the foils to chromate treatment and/or silane coupling agent treatment.

In addition, the copper foils can be expected to have remarkably satisfactory haloing resistance as compared with copper oxide obtained by black oxide treatment since the electrodeposited micro-protrusions electrolytically formed on the copper foils are made of metallic copper.

Thus, the copper foils of the present invention make it possible to simplify the process by dispensing with the black oxide treatment and simultaneously improve the resulting circuit boards in quality when there are manufactured high-density multilayer printed circuit boards which will predominantly be demanded as printed circuit boards from now on.

**Claims**

1. Copper foils for use in an inner-layer of a high-density multilayer printed circuit board, comprising electrodeposited protrusions which have 0.2 to 2 μm in height on their glossy side, and acicular or nodular electrodeposited micro-protrusions which have 0.05 to 0.5 μm in height on their matte side.

2. Copper foils according to claim 1, wherein the copper foils further comprise acicular or nodular electrodeposited micro-protrusions on a layer of the electrodeposited protrusions formed on their glossy side.

3. Copper foils according to claim 1, wherein the copper foils further comprise rust-preventive layers on the protrusions of their glossy and matte sides.

4. A high-density multilayer printed circuit board, wherein the copper foils of claim 1 are laminated on an inner-layer substrate with the glossy side of the copper foils facing thereto thereby to fabricate an inner layer circuit.

**Patentansprüche**

1. Kupferfolien zur Verwendung in einer Innenschicht einer hochdichten, mehrschichtigen Leiterplatte, die galvanisch abgeschiedene Vorsprünge mit einer Höhe von 0,2 bis 2 μm auf ihrer glänzenden Seite und nadelförmige oder kugelförmige galvanisch abgeschiedene Micro-Vorsprünge mit einer Höhe von 0,05 bis 0,5 μm auf ihrer matten Seite umfassen.

2. Kupferfolien gemäß Anspruch 1, worin die Kupferfolien weiterhin nadelförmige oder kugelförmige galvanisch abgeschiedene Micro-Vorsprünge auf einer Schicht auf den galvanisch abgeschiedenen Vorsprüngen, die auf ihrer glänzenden Seite gebildet wurden, umfassen.

3. Kupferfolien gemäß Anspruch 1, worin die Kupferfolien weiterhin Rostschutzschichten auf den Vorsprüngen auf ihren glänzenden und matten Seiten umfassen.

4. Eine hochdichte, mehrschichtige Leiterplatte, worin die Kupferfolien von Anspruch 1 auf einem Innenschicht-Substrat laminiert sind, wobei ihm die glänzende Seite der Kupferfolien zugewandt ist, um einen Innenschicht-Schaltkreis herzustellen.

**Revendications**

1. Feuilles de cuivre pour une utilisation dans une couche interne d'une carte à circuits imprimés multicouche à haute densité, comprenant des saillies déposées par électrolyse qui ont une hauteur de 0,2 à 2 µm sur leur face brillante, et des microsaillies aciculaires ou nodulaires déposées par électrolyse qui ont une hauteur de 0,05 à 0,5 µm sur leur face mate.

2. Feuilles de cuivre selon la revendication 1, dans lesquelles les feuilles de cuivre comprennent de plus des microsaillies aciculaires ou nodulaires déposées par électrolyse sur une couche des saillies déposées par électrolyse formées sur leur face brillante.

3. Feuilles de cuivre selon la revendication 1, dans lesquelles les feuilles de cuivre comprennent de plus des couches antirouille sur les saillies de leurs faces brillante et mate.

4. Carte à circuits imprimés multicouche à haute densité, dans laquelle les feuilles de cuivre de la revendication 1 sont appliquées sur un substrat de couche interne avec la face brillante des feuilles de cuivre faisant face à celui-ci pour fabriquer ainsi un circuit de couche interne.

011151 5.0 kV X5.00K 6.00μm

FIG. 1

009195 5.0 kV X5.00K 6.00μm

FIG. 2

FIG. 3

outer – layer copper foil
outer – layer substrate
inner – layer copper foil
inner – layer substrate
inner – layer copper foil
outer – layer substrate
outer – layer copper foil

FIG. 4